# EUROPÄISCHE PATENTSCHRIFT

(11) **EP 0 452 352 B1**
(45) Veröffentlichungstag und Bekanntmachung des Hinweises auf die Patenterteilung: **03.05.1995**
(21) Anmeldenummer: 90900868.2
(22) Anmeldetag: 23.12.1989
(51) Int. Cl.: C04B 35/00, H01L 39/24

(54) **MEHRPHASIGER SUPRALEITER UND VERFAHREN ZU SEINER HERSTELLUNG**
MULTIPHASE SUPERCONDUCTOR AND PROCESS FOR MANUFACTURING IT
SUPRACONDUCTEUR POLYPHASE ET SON PROCEDE DE PRODUCTION

(30) Priorität: 29.12.1988 DE 3844207
(43) Veröffentlichungstag der Anmeldung: 23.10.1991
(73) Patentinhaber: HOECHST AKTIENGESELLSCHAFT, 65926 Frankfurt am Main (DE)
(72) Erfinder: BECKER, Winfried, D-6233 Kelkheim (DE)
(86) Internationale Anmeldenummer: EP8901605
(87) Internationale Veröffentlichungsnummer: WO9007475

(56) Entgegenhaltungen:
- EP-A- 0 284 061
- EP-A- 0 284 062
- Japanese Journal of Applied Physics, Band 27, Nr. 2, 2. Februar 1988, H. Maeda et al.: "A new high-Tc oxide superconductor without a rare earth element" Seiten L209-L210

## Beschreibung

Die Vorliegende Erfindung betrifft einen mehrphasigen keramischen Supraleiter, der die nicht-supraleitende Phase Strontiumindat und mindestens eine supraleitende Phase bestehend aus den Elementen Wismut, Strontium, Kalzium, Kupfer und Sauerstoff enthält, sowie ein Verfahren zu ihrer Herstellung.

Die Verbindung Strontiumindat, SrIn₂O₄ ist seit längerem bekannt (Z. Naturforschung 19b (1967) 955).

Es ist bekannt, daß keramische Supraleiter, die aus den Elementen Wismut, Strontium, Kalzium, Kupfer und Sauerstoff aufgebaut sind, i.a. nur geringe Anteile einer bei 110 K supraleitenden Phase enthalten.

Es bestand daher die Aufgabe, ein Verfahren zu finden, um den Anteil der bei 110K supraleitenden Phase im Supraleiter-Körper zu erhöhen. Die Vorliegende Erfindung löst dieses Problem.

Der Erfindung liegt die Erkenntnis zugrunde, daß der Anteil der bei 110 K supraleitenden Phase, die aus den Elementen Wismut, Strontium, Kalzium, Kupfer und Sauerstoff besteht, erhöht wird, wenn die Phasenbildung in Gegenwart von Strontiumindat stattfindet.

Es wurde nun ein Verfahren zur Herstellung eines Supraleiters gefunden, der mindestens eine aus den Elementen Wismut, Strontium, Kalzium, Kupfer und Sauerstoff aufgebaute supraleitende Phase enthält, wobei man ein Gemisch der Oxide von Wismut, Strontium, Kalzium und Kupfer oder entsprechender Oxidvorläufer vermischt und dabei ein Atomverhältnis der Elemente einhält, das einer Bruttozusammensetzung Bi₄(Sr,Ca)ₖCuₖ₋₂Oₓ entspricht, wobei k eine Zahl von 4 bis 8 ist und das Atomverhältnis Sr/Ca 1:9 bis 9:1 beträgt, und man die Mischung in Anwesenheit von Sauerstoff längere Zeit erhitzt. Das Verfahren ist dadurch gekennzeichnet, daß man dem Gemisch vor dem Erhitzen im allgemeinen die 0,428- bis 9-fache Menge an Strontiumindat-Pulver zusetzt. Vorzugsweise wird die dreifache Menge an Indat untergemischt.

Anstelle von Strontiumindat kann man auch die Mischkristallverbindung Strontium/Kalzium-Indat mit allen Atomverhältnissen Sr/Ca, z.B. auch reines Calciumindat, CaIn₂0₄, benutzen.
Die genannten Indate sind unter den Bedingungen der Synthese des Supraleiters inert. Der zugesetzte Anteil an Indat findet sich daher im erhaltenen keramischen Supraleiter wieder.

Man kann auch das (Ca,Sr)In₂0₄ in situ aus den Erdalkalioxiden und Indiumoxid oder Indiumcarbonat z.B. nach der Gleichung

0,4 CaCO₃ + 0,6 SrC0₃ + In₂0₃ → (Ca,Sr)In₂0₄ + CO₂

bereiten. In diesem Fall sollte der Ansatz zur Herstellung des Supraleiters einen der Indiumoxidmenge äquimolaren Überschuß an Erdalkalioxid aufweisen. Wichtig ist, daß zugesetztes Indat in feinpulvriger Form vorliegt und mit dem indiumfreien Ansatz gründlich gemischt wird.

Nach dem angegebenen Verfahren lassen sich Supraleiter herstellen, die neben Strontiumindat mindestens eine der supraleitenden Phasen Bi₄(Sr,Ca)₄Cu₂Oₓ oder Bi₄(Ca,Sr)₆Cu₄Oₓ oder Bi₄(Ca,Sr)₈Cu₆Oₓ enthalten, wobei jeweils das Atomverhältnis Ca/Sr von 1:9 bis 9:1 beträgt.

Die neuen Supraleiter lassen sich dadurch herstellen, daß man Oxide oder Oxidvorläufer der Elemente Bi, Sr, Ca und Cu zusammen mit SrIn₂0₄ gründlich vermischt und das Gemisch auf Temperaturen von mindestens 700°C erhitzt.

Während der Reaktion ändert sich das Atomverhältnis der eingesetzten Metalle in erster Näherung nicht. Das verwendete Atomverhältnis entspricht daher der angestrebten Oxidzusammensetzung.

Als Oxidvorläufer lassen sich allgemein Verbindungen, die bei der Reaktionstemperatur zu den entsprechenden Oxiden reagieren, einsetzen, insbesondere die Hydroxide und Nitrate. Verwendbar sind ferner die Acetate, Formiate, Oxalate sowie Carbonate der genannten Metalle. Verwendbar sind z.B. Calciumoxid, Strontiumcarbonat, Wismutsäure, Wismut-III-oxid, Wismut-V-oxid, Cu₂O und CuO.

Das Reaktionsgemisch braucht nicht oder nur teilweise zu schmelzen. In diesem Fall ist es jedoch erforderlich, längere Zeit bei der Reaktionstemperatur zu halten.

Die Synthesetemperatur liegt in diesem Fall vorzugsweise im Bereich zwischen 700 und 900°C, vorzugsweise 750 bis 800°C.

Die Reaktionszeit soll mindestens 4 Stunden, noch besser mindestens 8 Stunden betragen. Nach oben wird die Reaktionszeit nur durch wirtschaftliche Überlegungen begrenzt. Reaktionszeiten von 100 oder 120 Stunden sind möglich.

Man kann auch das Gemisch so hoch erhitzen, daß es vollständig geschmolzen ist. In diesem Fall kann rasch auf Temperaturen von 300 - 900°C abgekühlt und längere Zeit (mindestens eine Stunde, vorzugsweise 4 Stunden) in diesem Bereich gehalten werden.

Vorteilhafterweise kann man die Schmelze auf einem Substrat auftragen und dort erstarren lassen. Nach der anschließenden Temperbehandlung erhält man so kompakte Schichten des Supraleiters auf einer Unterlage. Das Substrat (Unterlage) soll nicht mit dem Reaktionsgemisch reagieren. Geeignet sind z. B. Al₂O₃, SiO₂ (Quarz), ZrO₂, SrIn₂0₄_{,} Strontiumtitanat und Bariumtitanat, sowie Metalle wie Stahl und Cr-Ni-Legierungen.

Man kann auch die Schmelze verspinnen. Dabei fallen Drähte an, die nach Tempern ebenfalls supraleitend sind.

Die eigentliche Reaktion soll in einer nicht-reduzierenden Atmosphäre stattfinden. Verwendbar sind z.B. Luft, reiner Sauerstoff, Gemische von O₂/Ar oder O₂/N₂. Es ist bevorzugt, wenn die Umsetzung der Oxide in einer Sauerstoff enthaltenden Atmosphäre durchgeführt wird.

Nach beendeter Reaktion wird die Probe entweder aus dem Ofen entnommen und in Luft oder Sauerstoff oder im Ofen langsam auf Raumtemperatur abgekühlt. Niedrige Abkühlungsgeschwindigkeiten wirken sich günstig auf die supraleitenden Eigenschaften des Reaktionsprodukts aus.

Um sicherzustellen, daß sich das gesamte Oxidgemisch umgesetzt hat, ist es vorteilhaft, das erhaltene Pulver nach dem Abkühlen weiter zu zerkleinern und erneut thermisch zu behandeln. Bei dieser Nachbehandlung liegt die Temperatur im Bereich von 300 bis 900°C.

Bevorzugte Untergrenzen der Temperatur der Nachbehandlung liegen bei mindestens 300°C, insbesondere 400°C, eine bevorzugte Obergrenze bei 750°C, besser 600°C, insbesondere 550°C. Die mögliche Nachreaktion soll in Luft, reinem Sauerstoff, oder einem Gasgemisch wie O₂/Ar oder O₂/N₂ durchgeführt werden. Als Reaktionsgefäße können handelsübliche Tiegel oder Schiffchen aus inerten Materialien, wie z.B. Aluminiumoxid, Zirkon, Platin und Iridium oder SrIn₂0₄ benutzt werden, Als Wärmequelle eignen sich handelsübliche Öfen, wie z.B. Kammer-, Muffel- oder Rohröfen.

Ein weiteres Verfahren zur Herstellung der supraleitenden Substanzen besteht darin, daß man Salze der genannten Metalle in Gegenwart einer wäßrigen Phase vermischt, das wasserhaltige Salzgemisch eindampft und bei Temperaturen von mindestens 700°C erhitzt. Mindestens eines der eingesetzten Salze soll wasserlöslich sein und die Salze sollen sich im angegebenen Temperaturbereich zu den Oxiden zersetzen. Hinsichtlich der Reaktionszeit gilt das gleiche wie bei Verwendung der Oxide.

Das einzudampfende Salzgemisch läßt sich auch dadurch herstellen, daß man die Metalloxide in Salpetersäure löst und die Salpetersäure abraucht.

Man kann auch, soweit wasserlösliche Salze eingesetzt werden, durch Zugabe einer Base, z.B. Tetramethylammonium-Hydroxid die Metallhydroxide ausfällen. Auf diese Weise gelingt es, ein besonders gründliches Vermischen der Ausgangsprodukte zu erzielen. Die ausgefällten Hydroxide können abgetrennt, getrocknet und dann wie oben angegeben getempert werden. Vorzugsweise werden durch die verwendete Base keine schwer flüchtigen Kationen und durch die eingesetzten Salze keine schwer flüchtigen Anionen eingeschleppt.

Auch bei dieser Ausgestaltung des erfindungsgemäßen Verfahrens entspricht das Atomverhältnis der eingesetzten Metallsalze dem angestrebten Atomverhältnis des Endproduktes. Die aus den Salzen hergestellten oxidischen Produkte lassen sich, wie oben beschrieben, ebenfalls thermisch nachbehandeln.

Im allgemeinen enthält der Ansatz schwarze Kristalle der Phasen Bi₄ (Sr,Ca)ₖ Cuₖ₋₂ Oₓ wobei gleichzeitig nebeneinander Kristalle mit k = 4 (T_{c} = 60 K), k = 5 (T_{c} = 85 K) und k = 6 (T_{c} = 110 K) vorliegen.

Überraschenderweise lassen sich beim erfindungsgemäßen Verfahren aus Laborchemikalien mit einer Reinheit von nur etwa 99,5 % supraleitende Substanzen gewinnen.

Die gewonnenen supraleitenden Substanzen lassen sich in der Energietechnik (für Kabel und Drähte, Transformatoren, und Energiespeicher in Form stromdurchflossener Spulen) in der Magnettechnologie (z.B. für Kernspintomographen und zur Herstellung von Haltemagneten für Schwebebahnen) in der Computertechnik (dünne Schichten, Verbindungen auf Leiterplatten , Josephson-Schaltelemente) und für elektronische Bauelemente (Detektoren, Antennen, Transistoren, elektronische Sensoren, z.B. SQUIDs, Galvanometer, Modulatoren, Bolometer und SLUGs) verwenden. Die Anwendung der Supraleitung in der Meßtechnik wird behandelt in dem gleichnamigen Aufsatz von Prof. F. Baumann, Karlsruhe, in einer Aufsatzreihe des VDI-Bildungswerks (1976).

Die Erfindung wird durch die Beispiele näher erläutert.

### Beispiel

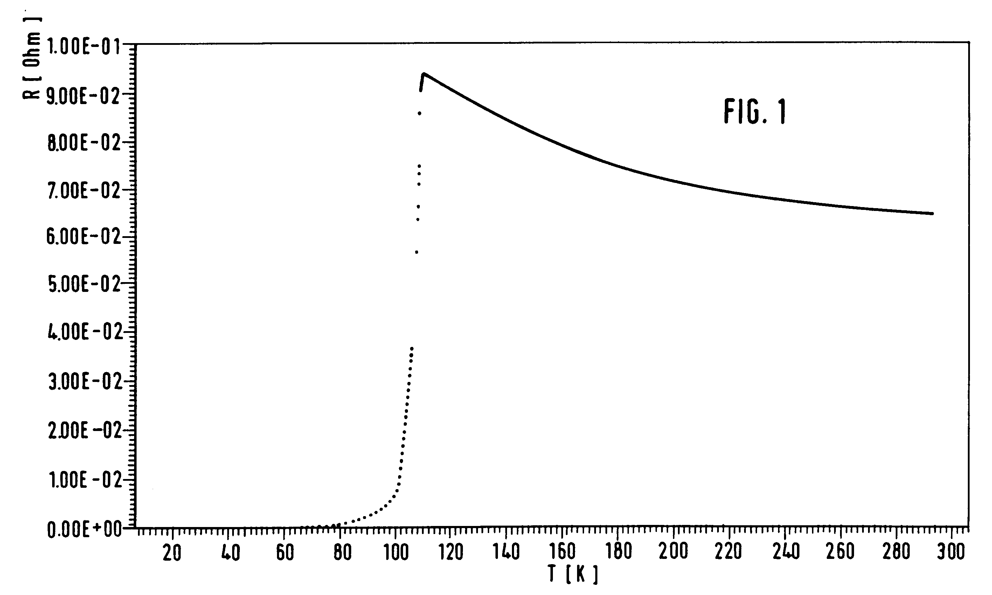

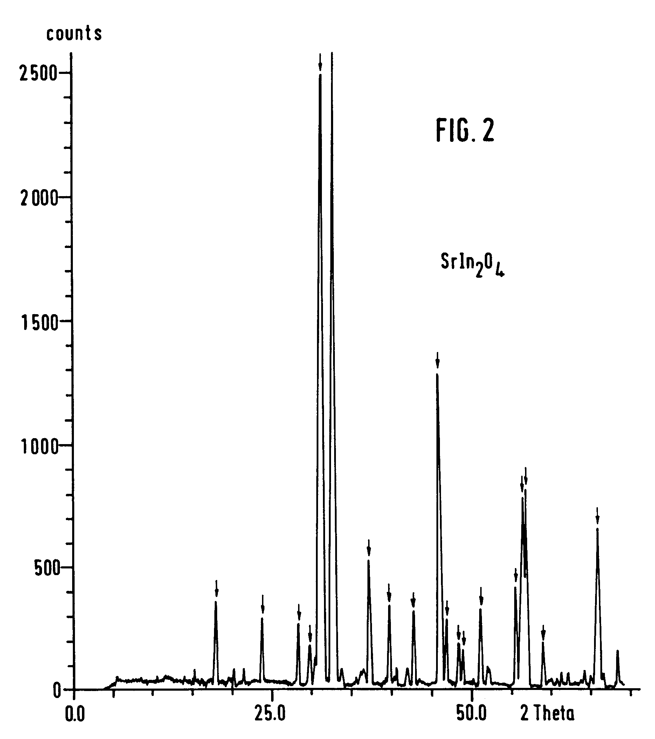

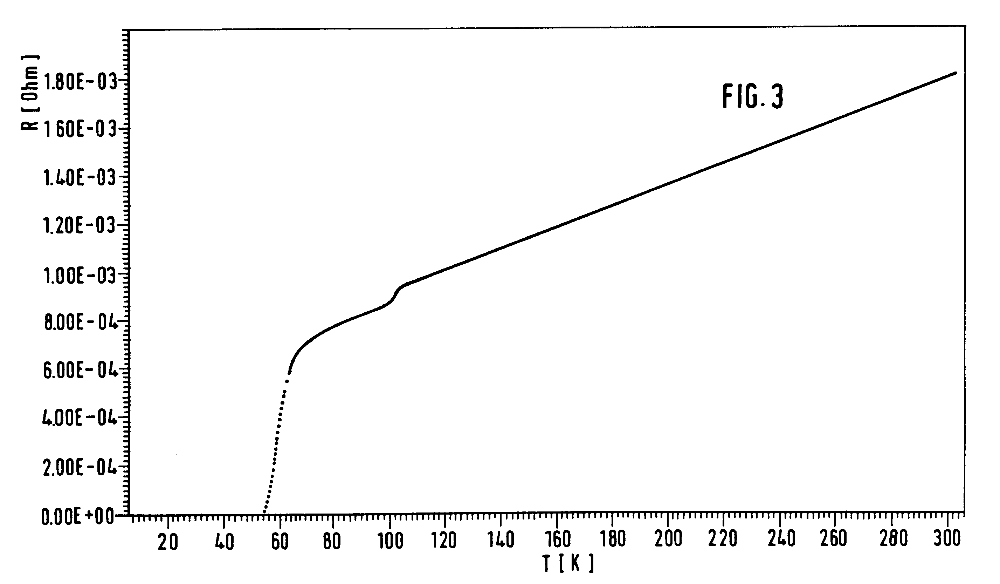

Es werden 3,1250 g In₂O₃, 1,7508 g Bi₂O₃, 0,8763 g CaO, 4,4736 g SrCO₃ und 2,4106 g CuO eingewogen und in einem Achatmörser innig gemischt. Die Mischung wird anschließend in einem Korundtiegel 6 Stunden bei 800 °C vorreagiert. Die Temperatur wird dann auf 1000 °C gesteigert und 6 h bei 1000 °C gehalten. Danach kühlt man in 4 Stunden auf 300 °C ab und entnimmt die Probe mit der Bruttozusammensetzung Bi_{0,5}In_{1,5}Sr₂CaCu₂Oₓ. Die Probe wird wiederum in einem Achatmörser homogenisiert und dann zu Tabletten (Durchmesser: 1 cm, Dicke: ca. 2 mm) verpreßt. Diese werden dann 30 Stunden bei 1000 °C auf einer Unterlage aus Al₂O₃ gesintert und nach Abkühlung auf 100 °C (3 Stunden) dem Ofen entnommen. Eine so hergestellte Probe zeigt eine kritische Temperatur von 102 K (Fig.1 ). Im Röntgendiagramm findet man im wesentlichen SrIn₂O₄ und Bi-haltige Supraleitende Phasen. Das Röntgendiagramm von SrIn₂O₄ ist in Fig. 2 dargestellt.
Der Vergleich von Fig. 1 mit Fig. 3 (Herstellung eines Supraleiters der Bruttozusammensetzung Bi₄ Sr₃Ca₃ Cu₆ 0₁₈₊ₐ ohne Indium-Zusatz) zeigt, daß die Anwesenheit von SrIn₂O₄ im Reaktionsansatz die Bildung der 110 K-Phase günstig beeinflußt.

In Fig. 1 und 3 ist jeweils die Abhängigkeit des Widerstands R (Ohm) von der absoluten Temperatur T (K) dargestellt.

## Patentansprüche

1. Mehrphasiger,keramischer Supraleiter, der
a) einen oxidkeramischen Supraleiter der Bruttozusammensetzung Bi₄(Sr,Ca)ₖCuₖ₋₂Oₓ, wobei k eine Zahl von 4 - 8 ist und das Atomverhältnis Sr/Ca 1:9 bis 9:1 beträgt, und
b) die nicht supraleitende Phase Strontiumcalciumindat (Sr,Ca)In₂O₄ mit einem Atomverhältnis Sr/Ca von 1:0 bis 0:1
mit einem Gewichtsverhältnis ab von 1:0.428 bis 1:9 enthält.

2. Keramischer Supraleiter gemäß Anspruch 1, dadurch gekennzeichnet, daß er 30 - 90 Gew.-% Strontiumcalciumindat enthält.

3. Supraleiter gemäß Anspruch 1 oder 2, dadurch gekennzeichnet, daß er die Phase Bi₄(Sr,Ca)₄ Cu₂Oₓ enthält, wobei das Atomverhältnis Strontium/Calcium 1:9 bis 9:1 beträgt.

4. Supraleiter gemäß Anspruch 1 oder 2, dadurch gekennzeichnet, daß er die Phase Bi₄(Ca,Sr)₆Cu₄Oₓ enthält, wobei das Atomverhältnis Calcium/Strontium 1:9 bis 9:1 beträgt.

5. Supraleiter gemäß Anspruch 1 oder 2, dadurch gekennzeichnet, daß er die supraleitende Phase Bi₄(Ca,Sr)₈Cu₆Oₓ enthält, wobei das Atomverhältnis Ca/Sr 1:9 bis 9:1 beträgt.

6. Verfahren zur Herstellung eines Supraleiters mit mindestens einer supraleitenden Phase, die aus den Elementen Wismut, Strontium, Calcium, Kupfer und Sauerstoff aufgebaut ist, wobei man die Oxide von Wismut, Strontium, Kalzium und Kupfer oder entsprechender Oxidvorläufer vermischt, und dabei ein Atomverhältnis der Elemente einhält, das einer Bruttozusammensetzung Bi₄(Sr,Ca)ₖCuₖ₋₂Oₓ entspricht, in der k eine Zahl von 4 bis 8 ist und das Atomverhältnis Sr/Ca 1:9 bis 9:1 beträgt, man dem Gemisch die 0,428- bis 9-fache Menge an Strontiumcalciumindat-Pulver mit einem Atomverhältnis Sr/Ca von 1:0 bis 0:1 zusetzt und damit gründlich vermischt und die Mischung in nichtreduzierender Atmosphäre für mindestens 4 Stunden erhitzt.

7. Verfahren gemäß Anspruch 6, dadurch gekennzeichnet, daß man das Strontiumcalcium-Indat in situ aus Strontiumoxid, Calciumoxid oder deren Oxidvorläufern und Indium-3-oxid bereitet.

## Claims

1. A multiphase ceramic superconductor which contains
a) an oxide ceramic superconductor of the overall composition Bi₄(Sr,Ca)ₖCuₖ₋₂Oₓ, where k is a number from 4 - 8 and the Sr/Ca atomic ratio is 1:9 to 9:1, and
b) the nonsuperconducting phase strontium calcium indate (Sr,Ca)In₂O₄ having an Sr/Ca atomic ratio of 1:0 to 0:1
with an a:b weight ratio of 1:0.428 to 1:9.

2. A ceramic superconductor as claimed in claim 1, which contains 30 - 90% by weight of strontium calcium indate.

3. A superconductor as claimed in claim 1 or 2, which contains the phase Bi₄(Sr,Ca)₄Cu₂Oₓ, where the strontium/calcium atomic ratio is 1:9 to 9:1.

4. A superconductor as claimed in claim 1 or 2, which contains the phase Bi₄(Ca,Sr)₆Cu₄Oₓ, where the calcium/strontium atomic ratio is 1:9 to 9:1.

5. A superconductor as claimed in claim 1 or 2, which contains the superconducting phase Bi₄(Ca,Sr)₈Cu₆Oₓ, where the Ca/Sr atomic ratio is 1:9 to 9:1.

6. A process for producing a superconductor containing at least one superconducting phase which is based on the elements bismuth, strontium, calcium, copper and oxygen, which process comprises mixing the oxides of bismuth, strontium, calcium and copper or corresponding oxide precursors and, at the same time, maintaining an atomic ratio of the elements which corresponds to an overall composition Bi₄(Sr,Ca)ₖCuₖ₋₂Oₓ, in which k is a number from 4 to 8 and the Sr/Ca atomic ratio is 1:9 to 9:1, adding 0.428 to 9 times the amount of strontium calcium indate powder having an Sr/Ca atomic ratio of 1:0 to 0:1 to the mixture and thoroughly mixing it therewith, and heating the mixture in a nonreducing atmosphere for at least 4 hours.

7. The process as claimed in claim 6, wherein the strontium calcium indate is prepared in situ from strontium oxide, calcium oxide or their oxide precursors and indium (3) oxide.

## Revendications

1. Supraconducteur, en céramique, à plusieurs phases, qui comprend :
a) un supraconducteur d'oxydes céramiques de formule brute Bi₄(Sr,Ca)ₖCuₖ₋₂Oₓ, k étant un nombre de 4 à 8 et le rapport atomique Sr/Ca étant compris entre 1:9 et 9:1, et
b). la phase non-supraconductrice d'indate de strontiumcalcium (Sr,Ca)In₂O₄ de rapport atomique Sr/Ca 1:0 à 0:1, dans un rapport pondéral a:b de 1:0,428 à 1:9.

2. Supraconducteur en céramique selon la revendication 1, caractérisé en ce qu'il contient de 30 à 90% en poids d'indate de strontrium-calcium.

3. Supraconducteur selon la revendication 1 ou 2, caractérisé en ce qu'il comprend la phase de Bi₄(Sr,Ca)₄Cu₂Oₓ, le rapport atomique strontium/calcium étant compris entre 1:9 et 9:1.

4. Supraconducteur selon la revendication 1 ou 2, caractérisé en ce qu'il comprend la phase de Bi₄(Ca,Sr)₆Cu₄Oₓ, le rapport atomique calcium/strontium étant compris entre 1:9 et 9:1.

5. Supraconducteur selon la revendication 1 ou 2, caractérisé en ce qu'il comprend la phase supraconductrice de Bi₄(Ca,Sr)₈Cu₆Oₓ, le rapport atomique Ca/Sr étant compris entre 1:9 et 9:1.

6. Procédé de préparation d'un supraconducteur comportant au moins une phase supraconductrice, formée des éléments bismuth, strontrium, calcium, cuivre et oxygène, procédé selon lequel on mélange les oxydes de bismuth, strontium, calcium et cuivre ou les précurseurs d'oxydes correspondants, dans une proportion atomique des éléments qui correspond à une formule brute Bi₄(Sr,Ca)ₖCuₖ₋₂Oₓ, dans laquelle k désigne un nombre de 4 à 8 et le rapport atomique Sr/Ca est compris entre 1:9 et 9:1, on ajoute au mélange de 0,428 à 9 fois sa quantité d'une poudre d'indate de strontium-calcium avec un rapport atomique Sr/Ca de 1:0 à 0:1, que l'on mélange intimement, et on chauffe le mélange en atmosphère non-réductrice pendant au moins 4 heures.

7. Procédé selon la revendication 6, caractérisé en ce que l'on forme l'indate de strontium-calcium in-situ avec de l'oxyde de strontium, de l'oxyde de calcium ou leurs précurseurs d'oxydes et de l'oxyde d'indium (III).
